# EUROPEAN PATENT APPLICATION

(11) **EP 0 805 159 A1**
(43) Date of publication of application: **05.11.1997**
(21) Application number: 97107072.7
(22) Date of filing: 29.04.1997
(51) Int. Cl.: C07F 9/32, G03F 7/029, C08F 2/50, C07F 9/40

(54) **Phosphorus containing alkyl or arylsulphonyl derivatives and method for preparing same**

(30) Priority: 29.04.1996 CA 2175302
(71) Applicant: Cytec Canada Inc., Markham, Ontario L3R 6E6 (CA)
(72) Inventor: Hillhouse, John Henry, Niagara Falls, Ontario, L2J 3Z6 (CA)
(74) Representative: Diehl, Hermann, Dr. Dipl.-Phys.

(57) **Abstract**

Novel bis(alk or arylsulphonyl)alkyl phosphine oxides are disclosed in addition to a method for the preparation thereof, their use as photoinitiators and photopolymerizable compositions thereof.

## Description

The present invention relates to novel bis(alk or arylsulphonyl)alkyl phosphine oxides, methods for producing same and their use as photoinitiators and in photopolymerizable compositions.

The use of various phosphine-containing compounds as photoinitiators has been practiced industrially for many years. The photoinitiators are employed primarily in the photopolymerization of ethylenically unsaturated compounds in the preparation of photoimaging compositions, adhesives, coating compositions and the like.

For example, U.S. Patent No. 3,668,093 discloses the use of various acyl phosphines such as trisbenzoylphosphine as photoinitiators whereas U.S. Patent No. 3,682,808 advocates the use of oxyphosphoranes for this purposes. U.S. Patent No. 4,292,152 and its division U. S. Patent No. 4,385,109 suggest the use, as photoinitiators, of various acylphosphine oxides, as do U.S. Patent Nos. 4,298,738; 4,324,744; and 4,710,523. In U. S. Patent No. 4,737,593 and its division U.S. Patent No. 4,792,632, there is taught the use of bisacylphosphine oxides containing two C=O groups which are disclosed as useful as initiators for photopolymerization. Copolymerizable photoinitiators are disclosed in U.S. Patent No. 4,922,004 wherein the photoinitiator contains a CR=CR structure and actually becomes a polymerized part of the polymerization product, e.g. coating. Various other phosphine oxides containing two C=O groups are taught in U.S. Patent No. 5,399,770 and its division U.S. Patent No. 5,472,992.

Acrylphosphine sulfides containing both P=O and C=O moieties are taught as photoinitiators in U.S. Patent No. 4,522,693.

One of the greatest deterrents to the use of phosphine-containing compounds as photoinitiators in the production of photo polymerized coatings, adhesives, etc., is the fact that many of the phosphine-containing compounds which are commercial and economically feasible are solids at room temperature. Therefore, when they are incorporated into a polymerizable reaction media they are either diluted with an appropriate solvent or they are added as solids. In each case, the process of their incorporation results in increased costs, handling precautions or other detrimental features.

Therefore, if economically feasible, easily handled, liquid photoinitiators were available, a long felt need in the art would be satisfied.

It is the object of the present invention to provide novel phosphine-containing compounds which overcome the above-mentioned drawbacks. This object is solved by the compounds according to independent claim 1, the method according to independent claim 5 and the composition according to claim 9. Further advantageous features, aspects and details of the invention are evident from the dependent claims, the description and the examples. The claims are to be understood as a first non-limiting approach to define the invention in general terms.

This invention relates to a novel class of bis(alk or arylsulphonyl)alkylphosphine oxides which has now been prepared. These oxides are liquid under normal conditions and, therefore, are useful, as such, as photoinitiators by merely blending them with photopolymerizable monomers in order to initiate the photopolymerization thereof. They require neither special handling nor other precautions attendant solid materials nor the use of solvents to dilute them.

The invention relates specifically to compounds having the formula: 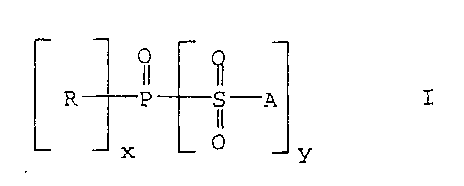 wherein each R is, individually, an alkyl group of C₁ - C₂₀, A is an aryl group or an alkyl group of C₁ - C₁₀, x and y are, individually, 1 or 2 and the total of x plus y is 3.

Preferably, R is an alkyl radical of C₁ - C₁₂ and A is an aryl group. Additionally, x is preferably 1. More preferably, R is an alkyl group of C₄ - C₈, especially isobutyl or 2,4,4-trimethylpentyl and A is phenyl.

These sulphonylphosphine oxides are liquid at ambient conditions and range from pale yellow to dark yellow in color. They are easily blended with other polymer additives to facilitate coatings, e.g. for wood, paper, and metal, etc.

The novel compounds represented by Formula I, above, may be prepared by reacting a compound having the formula: 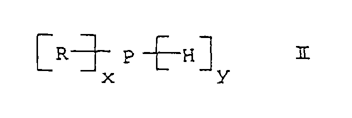 wherein R, x and y are as described above, with y moles of a compound having the formula:

ASO₂X

wherein A is as described above and X is an inert anion, such as a halide, an anhydride, etc.

The reaction is conducted at a temperature ranging from about 0° to about 60°C, preferably about 15° to about 45°C, under atmospheric pressure.

Oxidation of the reaction product to the desired oxide is effected by the use of any known oxidizing agent such as hydrogen peroxide, m-chloroperbenzoic acid and the like.

Any non-alcoholic, inert, solvent may be used to form the media in which the reaction is conducted with such solvents as aromatic hydrocarbons, e.g. benzene, toluene, etc.; halogenated aliphatic hydrocarbons such as dichloromethane, etc.; and mixtures thereof being exemplary. The aromatic hydrocarbons are preferred. Cyclohexane and aliphatic or aromatic ethers such as dioxane, dibutyl ether, etc., may also be used.

Promotors for the reaction include the amines such as triethylamine, pyridine, etc.; alkali metal carbonates such as sodium carbonate, potassium carbonate, etc., and mixtures thereof.

Suitable phosphine charge materials include methyl phosphine, dimethyl phosphine, ethyl phosphine, diethyl phosphine, butyl phosphine, dibutylphosphine, octyl phosphine, dioctyl phosphine, dodecyl phosphine, cyclohexylphosphine, dicylclohexyl phosphine, 2,4,4-trimethylpentyl phosphine, bis(2,4,4-trimethylpentyl) phosphine, didodecyl phosphine, stearyl phosphine, distearyl phosphine, methyl butyl phosphine, methyl octyl phosphine; butyl dodecyl phosphine and the like.

Suitable sulphonyl charge compounds include methane sulphonyl chloride, ethane sulphonyl chloride, butane sulphonyl chloride, octane sulphonyl chloride, decane sulphonyl chloride, cyclohexane sulphonyl chloride, benzyl sulphonyl chloride, toluene sulphonyl chloride, naphthyl sulphonyl chloride, 2-ethylbenzyl sulphonyl chloride, xylyl sulphonyl chloride, duryl sulphonyl chloride and their corresponding bromides, fluorides, iodides, anhydrides, etc.

The sulphonyl phosphine oxides may be recovered by distillation under reduced pressure. They exhibit excellent reactivity as photoinitiators for photopolymerizable monomers possessing at least one C=C bond and mixtures of such monomers. They show excellent shelf life and may be used alone or in conjunction with known photoinitiators. They are generally employed at a concentration of from about 0.001 to 20% by weight, preferably from about 0.1 - 5%, based on the weight of the photopolymerizable composition.

The compounds of the Formula I can be used according to the invention as photoinitiators for the photopolymerization of ethylenically unsaturated compounds of mixtures which contain such compounds having one or more olefinic double bonds. They may be of low molecular weight or relatively high molecular weight. Examples of such monomers are alkyl or hydroxyalkyl acrylates or methacrylates, e.g. methyl, ethyl, butyl, 2-ethylhexyl and 2-hydroxyethyl acrylate, isobornyl acrylate and methyl and ethyl methacrylate; acrylonitrile, acrylamide, methacrylamide, N-substituted (meth)acrylamides; vinyl esters, such as vinyl acetate, vinyl ethers, such as isobutyl vinyl ether, styrene, alkylstyrenes, halostyrenes, N-vinylpyrrolidone, vinyl chloride and vinylidenechloride, ethylene glycol diacrylate, propylene glycol diacrylate, neopentyl glycol diacrylate, hexamethylene glycol diacrylate, bisphenol A diacrylate, trimethylolpropane triacrylate, pentaerythritol triacrylate and tetraacrylate, pentaerythritol divinyl ether, vinyl acrylate, divinyl benzene, divinyl succinate, diallyl phthalate triallyl phosphate, triallyl isocyanurate, tris(2-acryloylethyl)isocyanurate; triethylene glycol divinyl ether, etc.

Examples of relatively high-molecular weight, polyunsaturated compounds are acrylated epoxy resins, acrylated polyethers, acrylated polyurethanes and acrylated polyesters; unsaturated polyester resins, which are usually prepared from maleic acid, phthalic acid and one or more diols and have molecular weights of from about 500 to 3,000.

Two-component mixtures of a prepolymer with a polyunsaturated monomer or three-component mixtures which also contain a monounsaturated monomer may also be used.

Two- and three-component systems of this type based on a prepolymer are used both for printing inks and for surface coatings, photoresists or other photocurable compositions.

Unsaturated polyester resins may be used in two-component systems together with a monounsaturated monomer, preferably styrene. For photoresists, specific one-component systems may be used, for example polymaleimides, polychalcones or polyimides.

The unsaturated compounds may also be used in a mixture with non-photopolymerizable film-forming compounds, for example nitrocellulose or cellulose acetobutyrate, polyisocyanates, polyepoxides or melamine resins.

In addition to the photoinitiator, the photopolymerizable mixtures may contain various additives, such as thermal inhibitors, for example hydroquinone or sterically hindered phenols. The shelf life may be extended by using, for example, copper compounds, phosphorus compounds, quaternary ammonium compounds or hydroxylamine derivatives. Atmospheric oxygen can be excluded during the polymerization by addition of paraffin or similar wax-like substances. As light stabilizers, UV absorbers, for example those of the benzotriazole, benzophenone, hydroxyphenyl-s-triazine or oxalanilide type may be added in small amounts as well as light stabilizers which do not absorb UV light, for example sterically hindered amines (HALS).

The photopolymerization can be accelerated by adding amines, for example triethanolamine, N-methyldithanolamine, ethyl p-dimethylaminobenzoate or Michler's ketone. Photosensitizers, which shift or broaden the spectral sensitivity, e.g. aromatic carbonyl compounds, for example derivatives of benzophenone, thioxanthone, anthraquinone and 3-acrylcoumarin, and 3-(aroylmethylene)thiazolines, may also be added.

Other conventional additives are, depending on the application, optical brighteners, fillers, pigments, dyes, wetting agents or flow-control agents.

The photoinitiators of the Formula I according to the invention are particularly suitable for curing photopolymerizable compositions which contain substances which reduce the transparency.

Thick and pigmented coatings can be cured by addition of glass microbeads or powdered glass fibers.

The invention therefore also relates to photopolymerizable compositions comprising:
(a) at least one ethylenically unsaturated photopolymerizable compound and
(b) at least one compound of the Formula I as photoinitiator,
it being possible for the composition furthermore to contain another photoinitiator and/or other additives.

The radiation-curable, water-dispersed, film-forming prepolymers, which are frequently dissolved, are, for aqueous prepolymer dispersions, monofunctional or polyfunctional, ethylenically unsaturated prepolymers which are known *per se*, can be initiated by means of free radicals and have a weight average molecular weight of, for example, at least 400, in particular from 500 to 10,000. Prepolymers having higher molecular weights are also suitable, such as polyesters containing polymerizable C―C double bonds and having a maximum acid number of 10; polyethers containing polymerizable C―C double bonds; hydroxyl-containing products of the reaction of a polyepoxide containing at least two epoxide groups per molecule with at least one α,β-ethylenically unsaturated carboxylic acid, polyurethane (meth)acrylates and α, β-ethylenically unsaturated acrylic copolymers containing acrylic radicals. Also suitable are thioether adducts of polymerization prepolymers having weight average molecular weight of at least 600, a carboxyl group content of from 0.2 to 15% and a content of from 0.01 to 0.8 mol of polymerizable C―C double bonds per 100 g of prepolymer.

These radiation-curable, aqueous prepolymer dispersions may contain, as further additives, dispersion assistants, emulsifiers, antioxidants, light stabilizers, dyes, pigments, fillers, etc.

In certain cases, it may be advantageous to use mixtures of two or more of the photoinitiators according to the invention. It is of course also possible to use mixtures with known photoinitiators, for example mixtures with benzophenone, acetophenone derivatives, benzoin ethers, benzil ketals, monoacylphosphine oxides, further bisacylphosphine oxides, peresters or titanocenes.

The photopolymerizable compositions can be used for various purposes, for example as printing inks, as varnishes, as white paints, for example for wood or metal, as coating compositions, *inter alia* for paper, wood, metal or plastic, as colored pigmented paints, as daylight-curable coatings for buildings and road markings, for the preparation of clear or pigmented aqueous dispersions, for photographic reproduction processes, for image recording processes or for the production of printing plates which can be developed using organic solvents or aqueous-alkaline media, for the production of masks for screen printing, as dental filling materials, as adhesives, as etch or permanent resists and as solder stop masks for printed electronic circuits, for the preparation of composite materials (for example styrenic polyesters, which may contain glass fibers and other assistants) and other thick-layer compositions, for the coating or encapsulation of electronic parts or as coatings for optical fibers.

The photocurable compositions according to the invention are suitable, for example, as coating materials for substrates of all types, for example wood, paper, ceramics, plastics, such as polyesters and cellulose acetate films, and metals, such as copper, and aluminum, to which a protective coating or an image is to be applied by photopolymerization. The substrates can be coated by applying a liquid composition, a solution or suspension to the substrate for example, by dipping, brushing, spraying or reverse-roll coating. Examples of coating bases for photographic information recording are polyester or cellulose acetate films or plastic-coated papers; coating bases for offset printing plates are specially treated aluminum, and coating bases for the production of printed circuits are copper-coated laminates.

The mixtures according to the invention are also highly suitable for the production of printing plates for flexographic or letterpress printing.

A further area of application of photocuring is the coating of metals, for example the coating of sheeting, tubes, cans or bottle caps, and the photocuring of plastics coatings, for example of PVC-based floor covetings or wall coverings.

An example of photocuring of coatings on paper is the colorless coating of labels, record sleeves or book covers.

Also important is the use of photocurable compositions for imaging processes and for the optical production of information carders.

The photopolymerization is carried out by known methods of photopolymerization by exposure to sunlight or to light which has a high short-wave content. Examples of suitable light sources are mercury medium-pressure, high-pressure and low-pressure lamps, superactinic fluorescent tubes, metal halide lamps or lasers whose emission maxima are in the range between 250 and 450 nm. Laser light sources have the advantage that photomasks are unnecessary, since the controlled laser beam writes directly on the photocurable coating. If a combination of photosensitizers is used, relatively long-wave light or laser beams up to 600 nm can also be used.

The following examples are set forth for purposes of illustration only and are not to be construed as limitations on the present invention except as set forth in the appended claims. All parts and percentages are by weight unless otherwise specified.

### Example 1

A mixture of monoisobutylphosphine (8g, 0.09 mole) and pyridine (16 g, 0.20 mole) is added dropwise over one hour, with stirring, to a solution of benzenesulfonyl chloride (35 g, 0.20 mole) in toluene (300 ml) at 55°C under a nitrogen atmosphere. The mixture is maintained at 60°C for an additional four hours, then let cool slowly overnight. The mixture is extracted with water to remove the pyridine hydrochloride, then treated with 25% hydrogen peroxide at 50°C. After the oxidation is complete, the organic layer is extracted with water, dried over magnesium sulfate, and evaporated to give a pale yellow oil (20 g, 65%). Analysis of this material by GC/MS and ³¹P/NMR spectroscopy confirms the identity of the product as the bis(phenylsulfonyl) isobutylphosphine oxide.

### Example 2

A mixture of bis (2,4,4-trimethylpentyl) phosphine (50g, 0.20 mole) and pyridine (16 g, 0.20 mole) is added dropwise over 1.25 hours to a solution of benzenesulfonyl chloride (35 g, 0.20 mole) in toluene (300 ml) at 60°C under a nitrogen blanket. The mixture is maintained a further three hours at 60°C, then cooled, extracted with water and oxidized with 25% hydrogen peroxide as described in Example 1(at 60°C), to give, after workup, a pale yellow liquid (73 g, 80% yield) comprising bis (2,4,4-trimethylpentyl),monophenylsulfonyl phosphine oxide.

### Example 3

A mixture of mono 2,4,4-trimethylpentylphosphine (12 g, 0.08 mole) and triethylamine (18g, 0.18 mole) is added dropwise over one hour, to a solution of benzenesulfonyl chloride (30 g, 0.17 mole) in toluene (250 ml) at 60°C. The mixture is stirred at 60°C for an additional three hours, then washed with water and oxidized with 25% hydrogen peroxide as described in Example 1 to yield a pale yellow liquid (10g, 35%) comprising bis (phenylsulfonyl), 2,4,4-trimethylpentyl phosphine oxide.

### Example 4

The procedure of Example 1 is again followed except that the phosphine thereof is replaced by monocyclohexylphosphine. Bis (phenylsulphonyl) cyclohexylphosphine oxide is produced.

### Example 5

Example 2 is again followed except that the sulphonyl chloride is replaced by methane sulphonyl chloride. Bis (2,4,4-trimethylpentyl) methylsulphonyl phosphine oxide results.

### Example 6

Again following the procedure of Example 1, bis(tolylsulphonyl) stearylphosphine oxide results when toluene sulphonyl chloride and stearyl phosphine are used in lieu of the reactants thereof.

### Example 7

When Example 3 is followed except that the benzenesulphonyl chloride thereof is replaced by 2,4,6-trimethylbenzene sulphonyl chloride, a compound, bis (2,4,6-trimethylbenzylsulfonyl) 2,4,4-trimethylpentylphosphine oxide, results.

### Example 8

Diethylphosphine is used to replace the phosphine and naphthylsulphonyl chloride is used to replace the chloride of Example 2, with the product, diethyl naphthylsulphonyl phosphine oxide, resulting.

### Example 9

Example 3 is again followed. Bis (phenyl sulphonyl) decyclopentyl phosphine oxide results when the phosphine thereof is replaced by dicyclopentyl phosphine.

### Example 10

To a UV-hardenable binder composition comprising 150 parts of a commercially available epoxy acrylate and 50 parts of hexanediol diacrylate are added 10 parts of bis (phenylsulphonyl) isobutyl phosphine oxide (Example 1) with stirring. The resultant formulation is applied to the surface of a degreased glass plate to a thickness of about 50 µm and hardened in an irradiator under a Hg medium pressure lamp (80 watt/cm). A fully hardened coating results.

An analogous method is used to obtain like results with the compounds produced in Examples 2-9.

## Claims

1. A compound having the formula: 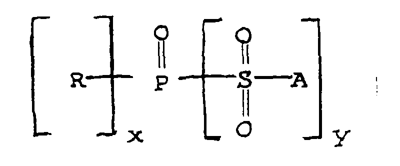 wherein each R is, individually, an alkyl group of C₁-C₂₀, A is an aryl group or an alkyl group of C₁-C₁₀, x and y are, individually, 1 or 2 and the total of x plus y is 3.

2. A compound according to claim 1 wherein R is isobutyl and A is phenyl.

3. A compound according to claim 1 wherein R is 2,4,4-trimethylpentyl and A is phenyl.

4. A compound according to one of the preceding claims wherein x or y is 1.

5. A method of producing a compound according to one of the preceding claims which comprises reacting a compound having the formula: 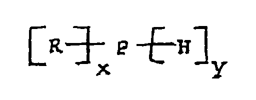 wherein each R is, individually, an alkyl group of C₁-C₁₀ and x and y are individually, 1 or 2, the total of x plus y being 3, with y moles of a compound having the formula
A-SO₂X
wherein A is an aryl group or an alkyl group of C₁-C₂₀ and X is an inert anion, and oxidising the resultant reaction product.

6. A method according to claim 5 wherein R is isobutyl and A is phenyl.

7. A method according to claim 5 wherein R is 2,4,4-trimethylpentyl and A is phenyl.

8. A method according to any one of claims 5 to 7 wherein x or y is 1.

9. A composition comprising
a) at least one ethylenically unsaturated photopolymerizable compound and
b) at least one compound having the formula: 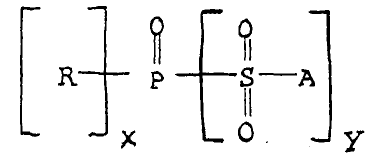 wherein each R is, individually, an alkyl group of C₁-C₂₀, A is an aryl group or an alkyl group of C₁-C₁₀, x and y are, individually, 1 or 2 and the total of x plus y is 3.

10. A photoinitiator according to claim 9 wherein R is isobutyl or 3,4,4-trimethylpentyl and A is phenyl.
